Europäisches Patentamt

European Patent Office

Office européen des brevets

(11) Publication number: **0 008 535**
**B1**

# (12) EUROPEAN PATENT SPECIFICATION

(45) Date of publication of patent specification: **13.02.85**

(21) Application number: **79301702.1**

(22) Date of filing: **20.08.79**

(51) Int. Cl.[4]: **H 01 L 29/743,** H 01 L 29/60, H 01 L 29/10

(54) **A gate controlled semiconductor device.**

(30) Priority: **18.08.78 JP 100726/78**

(43) Date of publication of application:
**05.03.80 Bulletin 80/05**

(45) Publication of the grant of the patent:
**13.02.85 Bulletin 85/07**

(84) Designated Contracting States:
**DE GB**

(56) References cited:
**DE-A-3 002 897**
**FR-A-2 299 727**
**GB-A-2 040 567**
**US-A-3 906 545**
**US-A-4 092 703**

**INTERNATIONAL JOURNAL OF ELECTRONICS,
vol. 36, no. 3, 1974, London, P.S. RADERECHT:
"The development of a gate assisted turn-off
thyristor for use in high frequency
applications", pages 399-416**

(73) Proprietor: **Kabushiki Kaisha Meidensha
1-17, Ohsaki 2-chome
Shinagawa-ku Tokyo 141 (JP)**

(72) Inventor: **Sueoka, Tetsuro
284-6, Toya
Numazu-shi, Shizuoka-ken (JP)**
Inventor: **Ishibashi, Satoshi
32-9, Higashimine-machi
Ota-ku, Tokyo (JP)**

(74) Representative: **Bardo, Julian Eason et al
Abel & Imray Northumberland House 303-306
High Holborn
London, WC1V 7LH (GB)**

(56) References cited:
**IEEE TRANSACTIONS ON INDUSTRY
APPLICATIONS, vol. IA-11, Sept./October 1975,
New York, H.J. RUHL et al. "A new rating
system for high-current high-frequency
thyristors", pages 540-545**

Courier Press, Leamington Spa, England.

## Description

The present invention relates to a a semiconductor device, and more particularly to an improved gate structure for a gate controlled semiconductor device.

A gate controlled semiconductor device such as, for example, a gate turn-off thyristor is constructed similarly to the more usual reverse-blocking three-terminal thyristor. The gate turn-off thyristor is switched from a non-conductive state to a conductive state by supplying a current to a gate electrode, when main current flows into the gate turn-off thyristor. The gate turn-off thyristor is returned to the nonconductive state from the conductive state by supplying a negative current, which is the current flowing in the reverse direction for reverse-biasing the cathode junction. The configuration of the cathode electrode is important to the turn-off performance of the device.

When a gate turn-off thyristor is turned off by supplying a reverse-biasing signal the reduction of the main current of the gate turn-off thyristor starts in the vicinity of the gate electrode, and spreads to the central portion and finally reaches the cathode-emitter layer. Various configurations of the cathode and the gate are used or proposed in order to enhance current interrupting capability. One method makes the transverse-resistance of the base layer small. In view of the above, the gate turn-off thyristor is designed so that the cathode electrode is located as near the gate electrode as possible, in order to eliminate the internal impedance between the cathode and the gate electrode. With this arrangement, the cathode electrode is divided into many small pieces and, as a result the length of the opposing faces of the cathode electrode and the gate electrode become inevitably long. The number of pieces of cathode electrode increases with capacity.

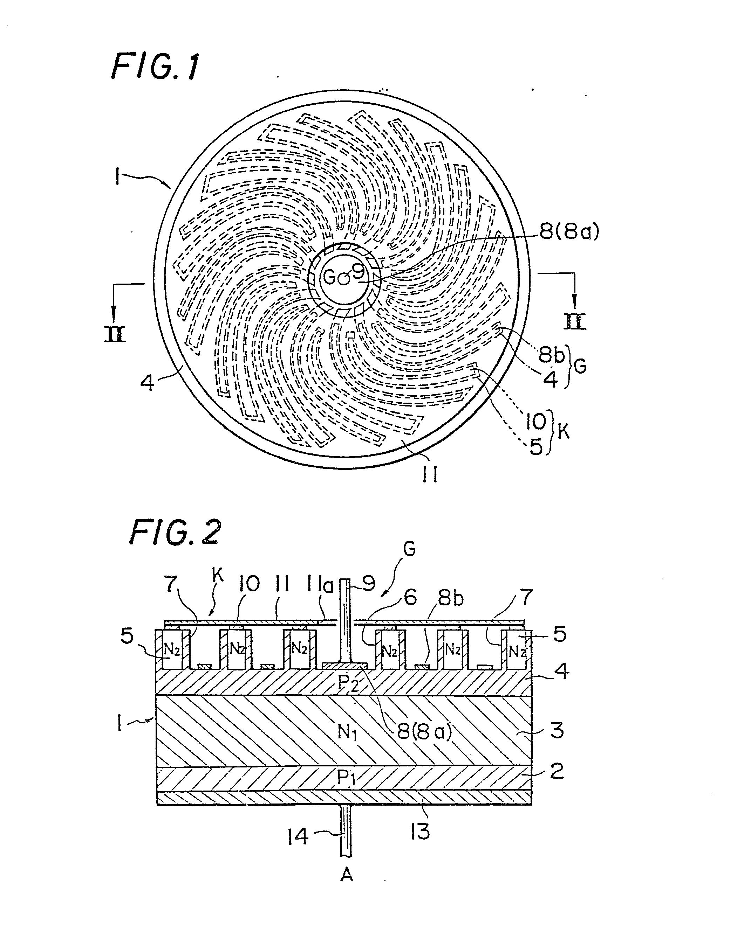

Figures 1 and 2 show an example of the conventional gate controlled semiconductor device in the form of a gate turn-off thyristor. A thyristor of this kind is shown in U.S. patent specification No. 4,092,703. In Figures 1 and 2, the reference numeral 1 shows a semiconductor element. The semiconductor element 1 comprises a $P_1$ layer 2 which is a P-type region, an $N_1$ layer bulk 3, $P_2$ layer 4 which is a P-type region and a plurality of $N_2$ layers 5 which are N-type regions.

The reference numeral 6 is a cavity provided on the centre portion of a surface of the $P_2$ layer 4. A plurality of involute-shaped slots 7 are provided on the surface of the $P_2$ layer 4 so as to communicate with the cavity 6. The slots 7 are spaced apart equidistantly. A metallic layer 8 is arranged in the cavity 6 and the slots 7, and the metallic layer 8 consists of a bridging segment 8a and a plurality of involute-shaped extensions 8b extending respectively along each slot 7 from the bridging segment 8a toward the periphery of the semiconductor element 1. A lead 9 is connected to the bridging segment 8a of the metallic layer 8 to form a gate electrode assembly G. A plurality of involute-shaped metallic layers 10 are provided, respectively, on each $N_2$ layer 5. A circular-metallic layer 11 having a bore 11a is secured on the metallic layers 10 to form a bridging member. K is the cathode electrode assembly. In the cathode electrode assembly K, the gap between adjacent emitter regions is the same over the entire assembly.

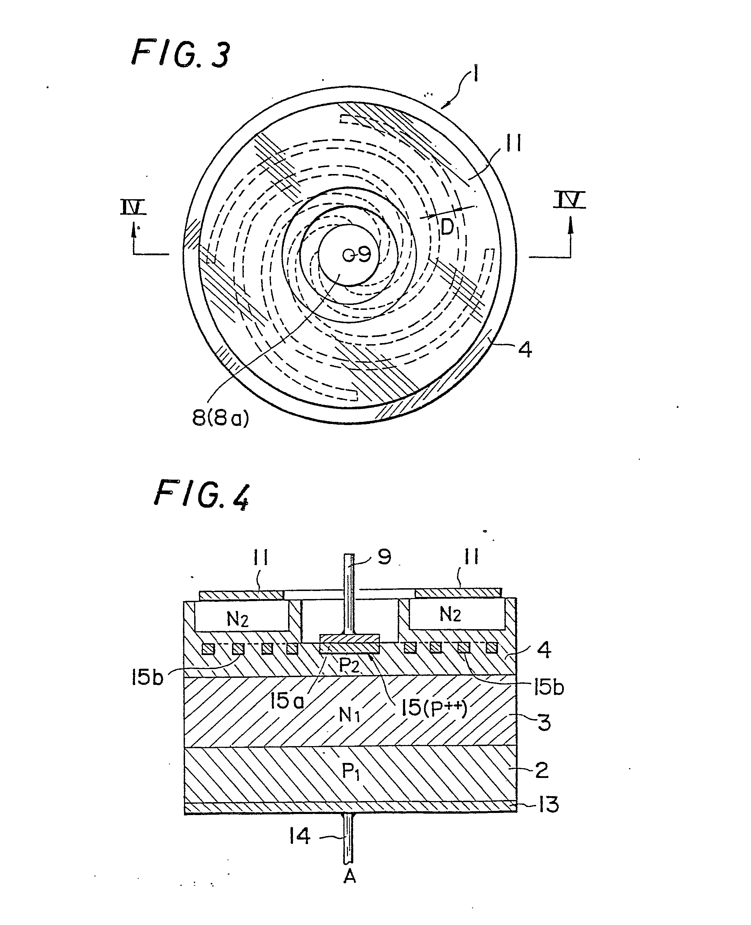

Figures 3 and 4 show an example of a gate turn-off thyristor in which a low resistance layer 15 is embedded in the $P_2$ layer 4. The low resistance layer 15 is embedded in the $P_2$ layer 4. The low resistance layer 15 is formed by diffusing a high concentration $P^{++}$-type impurity into the $P_2$ layer 4. The low resistance layer 15 consists of a circular-bridging portion 15a provided in the centre portion of the $p_2$ layer 4 and a plurality of involute-shaped extensions 15b extending radially and spirally from the bridging portion 15a toward the periphery of the conductive element 1. The distance D between adjacent extensions 15b is equal throughout, as in the case of the device of Figures 1 and 2. A metallic layer 8 is provided so as to contact the bridging portion 15a of the low resistance layer 15 to form a gate electrode assembly G. A ring shaped $N_2$ layer 5 is provided on the surface of the $P_2$ layer 4, and a ring shaped metallic layer 11 is secured on the $N_2$ layer 5 to form a cathode electrode assembly K. The device of Figures 3 and 4 is, an involute-type gate turn-off thyristor similar to that of Figures 1 and 2. In the device of Figures 3 and 4, the effective area of the element 1 is enhanced because of the $P^{++}$ layer 15 embedded in the $P_2$ layer 4. However, the strength against a reversing voltage between the gate electrode assembly G and the cathode electrode assembly K is superior to that of the device of Figures 1 and 2, because of the $P^{++}$ layer 15.

In the devices shown in Figures 1 and 2 and in Figures 3 and 4, when the element 1 is conductive, a main current flows from the anode electrode assembly A to the cathode electrode assembly K by way of the $P_1$ $N_1$ $P_2$ $N_2$ layers. In order to turn OFF the semiconductor element 1, an OFF signal is supplied to the gate electrode assembly G from the external gate lead 9, to sweep the main current out through the gate electrode assembly G.

During turn-off current flows toward the external gate electrode 9 from the cathode electrode assembly K and reverse biases the junction formed by the $P_2$ layer 4 and $N_2$ layer 5. In this case, the current flows from the cathode assembly K to the gate electrode assembly G, with the result that the portion of the $N_2$ layer 5 opposite to the gate electrode assembly G is turned OFF. In due course, each cathode portion is, in turn, returned to the OFF state.

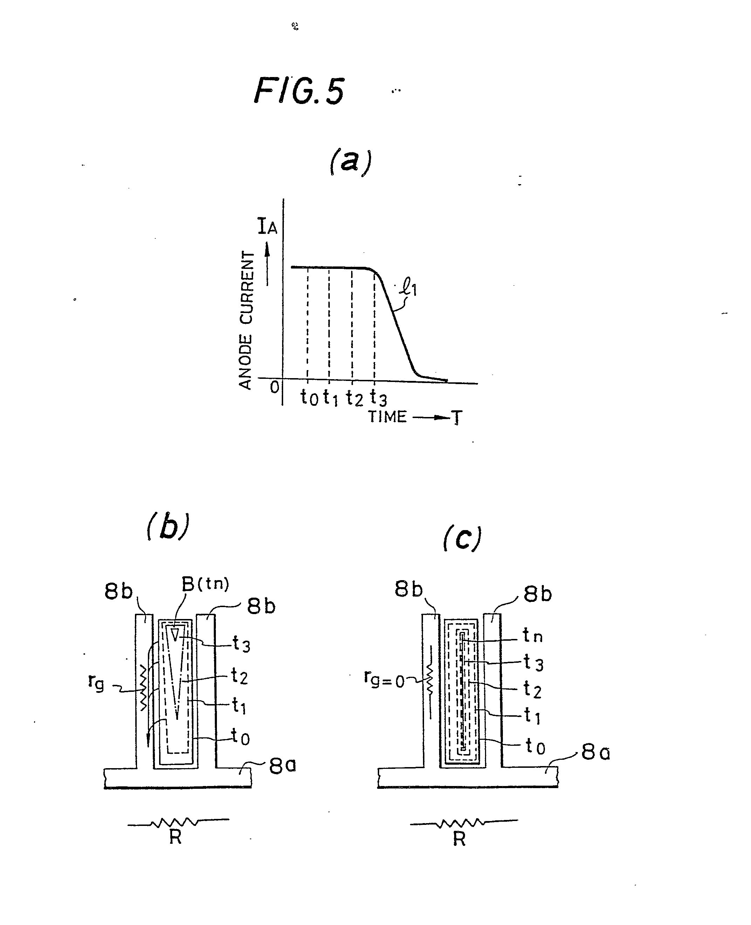

When the $N_2$ layer 5 which forms part of the cathode electrode assembly K is being swept of main current by the OFF signal supplied from the gate electrode assembly G, the current in the cathode region is turned OFF quickest if resistance does not exist in the gate electrode

**0 008 535**

assembly G. Figures 5b and 5c show two possible variations of conductive areas in a cathode area when the main current (anode current $I_A$ is turned OFF and Fig. 5a shows the general variation of current with time. The main current of the semiconductor element 1 is assumed to be turned off during the time interval $T = t_o$ to $t_n$, as is shown by a curve $1_l$ in Figure 5A, by the application of a reverse-bias signal to the cathode-emitter layer. The dotted lines in Figure 5C show how, if the transverse resistance value R and the resistance value $r_g$ of the gate electrode assembly G, respectively, are zero the turn OFF zones of the main current may vary with time. As shown in Figure 5C, the main current $I_A$ which flows in the region between the pair of extensions 8b is squeezed to a thin sheet at time $t_n$.

In the actual gate turn-off thyristor, there is some transverse resistance and gate resistance, so that some reverse-bias voltage is lost due to the impedance of the gate electrode assembly G. The reverse-bias voltage loss increases with the distance from the terminal of the gate electrode assembly G, and so the current flow contraction is as shown by the dotted lines of Figure 5B. Here, the turn OFF time of the main current $I_A$ in any part of the cathode electrode increases with the distance between the terminal of the gate electrode and that part of the cathode electrode and consequently, the main current $I_A$ is finally concentrated to region B which lies at the end portion of and on the centre line of the cathode area.

In the devices described above during turn off, the area occupied by the main current in the cathode electrode assembly K becomes progressively smaller and more removed from the gate terminal and therefore the main current $I_A$ is finally turned off when the gate impedance is highest because the gate current $I_g$ then flows through the longest current path. The arrangements described above are unsuitable for use in the manufacture of a large current capacity gate controlled semi-conductor device, since the current interrupting capability would be restricted by the length of the gate current path, and because it is important that the internal impedance of the gate electrode as well as the transvsrse resistance of the cathode layer should be low.

FR—A— 2 299 727 describes and illustrates a thyristor according to the precharacterising part of claim 1 in which the lower resistivity layer comprises parallel bars and has an exposed surface in the outer regions of the device carrying an annular metallic layer to which a turn-off gate terminal is connected. The specification also mentions that bars may alternatively be arranged like the radii of a circle, or be in the form of concentric circles, or spirals, or other more complex shapes.

It is an object of the present invention to provide a high performance gate controlled semi-conductor device.

According to the present invention a gate controlled semiconductor device comprises an element of semiconductor material having four regions of alternate conductivity types defining three series arranged junctions including, in seriatim, a first region containing first conductivity type dopant, a second region containing second conductivity type dopant, a third region containing first conductivity type dopant and a fourth region containing second conductivity type dopant, an anode electrode on the exposed surface of said first region, a turn-off gate electrode assembly extending across said element, and a metallic layer arranged on an exposed surface of said fourth region to provide a cathode electrode assembly, said turn-off gate electrode assembly including a layer which is of lower resistivity than and the same conductivity type as, the third region, and buried in the said third region, said lower resistivity layer having an exposed surface on which lies a metallic layer to which a turn-off gate terminal is connected, said lower resistivity layer including gaps and dividing the cathode electrode assembly into a plurality of effective cathodes, characterised in that, the effective cathodes extend in a plurality of directions between a central region of the device and outer regions of the device, in which outer regions the metallic gate layer is located, the effective cathodes are wider in the vicinity of the said outer regions than in the vicinity of the said central region of the device, and the circumferential widths of the parts of the lower resistivity layer bounding the said gaps are at a minimum at a central portion of the device and increase away from the said central portion.

The invention will be described more fully with reference to the drawings in which:—

Figure 1 is a plan view of a prior art gate controlled semiconductor device

Figure 2 is a vertical sectional view of the prior art gate controlled semiconductor device taken along line II—II of Figure 1,

Figure 3 is a plan view of another prior art gate controlled semiconductor device,

Figure 4 is a vertical sectional view of the prior art gate controlled semiconductor device taken along line IV—IV of Figure 3,

Figure 5A is a graph showing an anode current characteristic of a prior art gate controlled semiconductor device during turn-off,

Figure 5B is an enlarged plan view showing the turn-off current flow in a prior art gate controlled semiconductor device,

Figure 5C is an enlarged plan view showing the ideal turn-off current flow in a gate controlled semiconductor device.

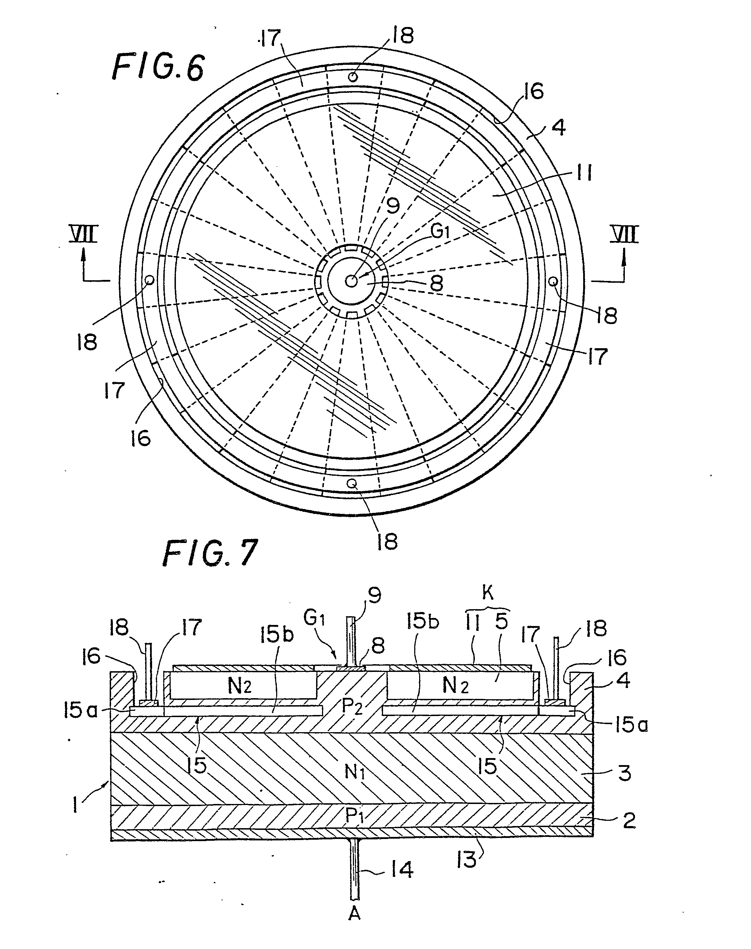

Figure 6 is a plan view of a gate controlled semiconductor device of the present invention,

Figure 7 is a vertical sectional view of the gate controlled semiconductor device of the present invention taken along line VII—VII of Figure 6,

With reference to Figures 6 and 7 of the drawings, in a gate controlled semiconductor device, a semiconductor element 1, the bulk of which is weakly N-type, includes a $P_1$ layer 2 which is a P-type diffused region, an $N_1$ bulk layer 3, a $P_2$ layer

4 which is a P-type diffused region and a ring shaped $N_2$ layer 5 which is an N-type diffused region.

A deivce of the kind described above is made essentially as follows.

First, a weakly N-type silicon wafer is prepared. Next $P_1$ and $P_2$ layers are grown over each of the end surfaces of the wafer by the diffusion of gallium. After that an $N_2$ cathode layer $5_2$ is formed by diffusion. Then, an aluminium layer is evaporated to form an ohmic contact. A metallic layer 8 is provided on a centre portion of the surface of the $P_2$ layer 4, and a lead 9 is connected to the metallic layer 8. A first gate electrode assembly $G_1$ comprises the $P_2$ layer 4, the metallic layer 8 and the lead 9.

As is best shown in Figures 6 and 7, a low resistance layer 15 is embedded in the $P_2$ layer 4. The low resistance layer 15 consists of a circular bridging portion 15a set in the outer portion of the $P_2$ layer 4 and a plurality of generally straight portions 15b extending radially from the bridging portion 15a, towards the centre portion of the $P_2$ layer 4. As is illustrated in Figure 6, each of the extending portions 15b of the low resistance layer 15 is sector-shaped so that the width of each extending portion 15b becomes gradually smaller towards the inner end. Accordingly, the width of the inner end portion of the effective emitter layer is smaller than the width of the outer end portion.

A circular slot 16 is provided on the surface of the $P_2$ layer 4 located at the outer side of the $P_2$ layer 4 by etching the surface of the $P_2$ layer 4 up to the upper surface of the bridging portion 15a of the low resistance layer 15. A circular metallic layer 17 is arranged in the slot 16 so as to contact the bridging portion 15a of the high density $P^{++}$ impurity layer 15. The metallic layer 17 is made by evaporating aluminium.

Terminal leads 18 are connected to the metallic layer 16. The leads 18 are relatively thick aluminium wires which have low impedance. This provides a second gate electrode assembly $G_2$ which includes the low resistance layer 15 consisting of the high impurity $P^{++}$ layer, bridging portion 15a and the plurality of sector-shaped extending portions 15b.

A cathode electrode assembly K is formed by the $N_2$ layer 5 and a metallic layer 11. The $N_2$ layer 5 is a main emitter layer arranged to act as a plurality of sector portions which form the effective emitter layer when the conductive element 1 is activated. It is important that each of the extensions 15b is formed of a radial sector in which the width of the inner portion is narrower than that of the outer end portion connected to the bridging portion 15a of the low resistance layer 15. The effective cathode layer is then divided into many pieces corresponding to the radial sectors.

In operation, an ON signal is applied to the first gate electrode assembly $G_1$ and, an OFF signal is applied to the second gate electrode assembly $G_2$. During turn-off the current in the element 1 is swept from the element by the second electrode

assembly $G_2$. When an ON signal is supplied between the cathode electrode assembly K and the first gate electrode assembly $G_1$, gate current flows in a circuit which is formed by the first gate electrode assembly $G_1$, the $P_2$ layer 4, the $N_1$ layer 3, the $N_2$ layer 5 (cathode layer) and part of the second gate electrode assembly $G_2$. The gate current causes a portion of the $N_2$ layer 5 on the side of the second gate electrode assembly $G_2$ to turn on, and main current begins to flow from the anode electrode assembly A to the cathode electrode assembly K. The conductive region of the $N_2$ layer 5 then spreads throughout the region of the $N_2$ layer 5 from the second gate electrode assembly side of the $N_2$ layer 5.

During turn off, gate turn off electron current flows toward the cathode electrode assembly K from the leads 18 of the second gate electrode assembly $G_2$ so as to apply reverse-bias to the junctions formed by the $P_2$ layer 4 and the $N_2$ layer 5 by way of a circuit formed by the circular metallic layer 17, the bridging portion 15a of the low resistance layer (the $P^{++}$ impurity layer 15), each of the extensions 15b of the $P^{++}$ impurity layer 15 and the $P_2$ layer 4.

During turn off of the device, the main current is simultaneously interrupted in the whole of the cathode layer, because the resistance values of all gate current paths are made equal by the width of the inner end portion of each of the extending portions 15b being smaller than that of the outer end portion. The ratio of the widths of the inner and outer end portions is set according to the resistance value in the radial direction of the low resistance layer 15 and the transverse resistance value of the P-type layer 4.

Gate controlled semiconductor devices constructed as shown in Figures 1 to 4 were compared with the gate controlled semiconductor device constructed as shown in Figures 6 and 7. In preparing a device as shown in Figs. 6 and 7, a $P_1N_1P_2$ sandwich was manufactured by diffusing gallium into an N-type silicon bulk, and then boron was diffused into sector-shaped parts of one surface of the $P_2$ layer so that the sheet resistance became $0.8\Omega/mm^2$ in those parts. A P-type layer was then formed on the boron diffused surface by an epitaxial method to give a bulk resistance of 15 $\Omega$-m and the ring-shaped cathode layer was formed on the surface of the P-type silicon layer by diffusing phosphorous selectively into the epitaxial layer.

For the gate controlled semiconductor devices constructed above, the gate current value required was to be 0.2 to 0.5 amperes and the forward voltage drop was to be 2.5 to 3.0 volts. Further the voltage rating was to be 850 to 1400 volts. The same performance was obtained in the prior art device and the device of the present invention for the gating current characteristic, the forward voltage drop and the voltage rating. In the prior art gate controlled semiconductor device, the turn-off time interval was 3.0 μs and the rated current was 150 to 200 amperes. In the gate controlled semiconductor device of the present invention, the turn-off time interval was 1.5 μs and the rated current was 200 to 400 amperes. As is obvious from the above data, the gate controlled semiconductor device of the present invention is superior to that of the prior art gate controlled semiconductor devices in respect of current capacity and turn-off characteristic.

The present invention is not limited to the above described embodiments and the invention is also applicable to other semiconductor devices such as, for example, a thyristor intended for use as an amplifying device, and the like.

As described with reference to the above embodiments, the gate controlled semiconductor devices include, as a means of improving switch-off performance, arrangements for reducing the internal impedance between a drain terminal of the turn-off gate electrode assembly and the region where the main current flow finally stops.

The following advantages are obtained: (1) the current interrupting capability is improved significantly in comparison with the prior art devices; (2) good performance is obtained from a relatively cheap gate turn-off thyristor; (3) fabrication is simplified in comparison with some conventional gate controlled semiconductor devices and therefore high-quality devices are obtained with good yield; and (4) reduction of the junction area is avoided, so that a high performance device is obtained without a corresponding loss of current capacity.

## Claims

1. A gate controlled semiconductor device comprising an element (1) of semiconductor material having four regions (2, 3, 4, 5) of alternate conductivity types defining three series arranged junctions including, in seriatim, a first region (2) containing first conductivity type dopant, a second region (3) containing second conductivity type dopant, a third region (4) containing first conductivity type dopant and a fourth region (5) containing second conductivity type dopant, an anode electrode (13) on the exposed surface of said first region, a turn-off gate electrode assembly (8, 15, 17) extending across said element (1), a metallic layer (11) arranged on an exposed surface of said fourth region (5) to provide a cathode electrode assembly (5, 11), said turn-off gate electrode assembly (8, 15, 17) including a layer (15) which is of lower resistivity than and the same conductivity type as, the third region, and buried in said third region (4), said lower resistivity layer (15) having an exposed surface on which lies a metallic layer (17) to which a turn-off gate terminal (18) is connected, said lower resistivity layer (15) including gaps and dividing the cathode electrode assembly (5, 11) into a plurality of effective cathodes, characterised in that, the effective cathodes extend in a plurality of directions between a central region of the device and outer regions of the device, in which outer regions the metallic layer (17) is located, the effective cathodes are wider in the vicinity of the said outer regions than in the vicinity of the said central region of the device, and the circumferential widths of the parts of the lower resistivity layer (15) bounding the said gaps are at a minimum at a central portion of the device and increase away from the said central portion.

2. A gate controlled semiconductor device as claimed in claim 1 further characterised in that the said parts of the lower resistivity layer (15) comprise a plurality of radially extending portions (15b).

3. A gate controlled semiconductor device as claimed in claim 2 further characterised in that the said radially extending portions define sectors of a circle.

4. A gate controlled semiconductor device as claimed in any preceding claim, further characterised in that a turn-on gate terminal (9) and a metallic layer (8) are provided at a central portion of the element (1).

## Revendications

1. Un dispositif semiconducteur commandé par électrode de commande, comprenant un élément (1) en matière semiconductrice comprenant quatre régions (2, 3, 4, 5) de types de conductivités définissant trois jonctions disposées en série et comprenant successivement une première région (2) contenant un dopant d'un premier type de conductivité, une seconde région (3) contenant un dopant d'un second type de conductivité, une troisième région (4) contenant un dopant d'un premier type de conductivité et une quatrième région (5) contenant un dopant d'un second type de conductivité, une électrode° anodique (13) placée sur la surface exposée de ladite première région, un ensemble d'électrodes de commande de blocage (8, 15, 17) s'étendant transversalement audit élément (1), une couche métallique (11) placée sur une surface exposée de ladite quatrième région (5) de façon à former un ensemble d'électrodes cathodiques (5, 11), ledit ensemble d'électrodes de commande de blocage (8, 15, 17) comprenant une couche (15) qui a une résistivité plus faible que la troisième région et qui est du même type de conductivité que celle-ci, et qui est enfouie dans ladite troisième région (4), ladite couche de plus faible résistivité (15) comportant une surface exposée sur laquelle est placée une couche métallique (17) à laquelle est reliée une borne de commande de blocage (18), ladite couche de plus faible résistivité (15) comprenant des intervalles et divisant l'ensemble d'électrodes cathodiques (5, 11) en une pluralité de cathodes effectives, caractérisé en ce que les cathodes effectives s'étendent dans une pluralité de directions entre une région centrale du dispositif et des régions extérieures du dispositif, régions extérieures dans lesquelles la couche métallique (17) est placée, les cathodes effectives étant plus larges au voisinage desdites régions extérieures qu'au voisinage de ladite région centrale du dispositif, et les largeurs circonférentielles des parties de la couche de plus faible résistivité (15) bordant lesdits intervalles sont minimales dans une partie centrale du dispositif et augmentent à partir de ladite partie centrale.

2. Un dispositif semiconducteur commandé par électrode de commande comme revendiqué dans la revendication 1, caractérisé en outre en ce que lesdites parties de la couche de plus faible résistivité (15) comprennent une pluralité de zones s'étendant radialement (15b).

3. Un dispositif semiconducteur commandé par électrode de commande comme revendiqué dans la revendication 2, caractérisé en outre en ce que lesdites zones s'étendant radialement définissent des secteurs d'un cercle.

4. Un dispositif semiconducteur commandé par électrode de commande comme revendiqué dans une quelconque des revendications précédentes, caractérisé en outre en ce qu'une borne de commande de mise en conduction (9) et une couche métallique (8) sont prévues dans une partie centrale de l'élément (1).

**Patentansprüche**

1. Von einem Gate gesteuerte Halbleiteranordnung mit einem Element (1) aus Halbleitermaterial mit vier Bereichen (2, 3, 4, 5) abwechselnden Leitungstyps, die drei in Reihe angeordnete Übergänge bilden, nämlich, hintereinander, einem ersten Bereich (2), der ein Dotiermittel des ersten Leitungstyps enthält, einem zweiten Bereich (3) der ein Dotiermittel des zweiten Leitungstyps enthält, einem dritten Bereich (4), der ein Dotiermittel des ersten Leistungstyps enthält und einem vierten Bereich (5), der ein Dotiermittel des zweiten Leitungstyps enthält, mit einer Anodenelektrode (13) auf der freiliegenden Oberfläche des ersten Bereichs, mit einer sich über das Element (1) erstreckenden Ausschalt-Gate-Elektrodenanordnung (8, 15, 17), mit einer auf der freiliegenden Oberfläche des vierten Bereichs (5) angeordneten Metallschicht (11) zur Bildung einer Kathodenelektrodenanordnung (5, 11), wobei die Ausschalt-Gate-Elektrodenanordnung (8, 15, 17) eine Schicht (15) mit geringerem spezifischem Widerstand als und dem Gleichen Leistungstyp wie der dritte Bereich enthält, die im dritten Bereich (4) vergraben ist, wobei die Schicht (15) mit geringerem spezifischem Widerstand eine freiliegende Oberfläche aufweist, auf der eine metallische Schicht (17) liegt, mit der der Ausschalt-Gateanschluß (18) verbunden ist, wobei die Schicht (15) mit geringerem spezifischem Widerstand Spalten aufweist und die Kathodenelektrodenanordnung (5, 11) in mehrere wirksame Kathoden unterteilt, dadurch gekennzeichnet, daß die wirksamen Kathoden sich zwischen einem mittleren und den äußeren Bereichen der Halbleiteranordnung, in denen die Metallschicht (17) angeordnet ist, in mehreren Richtungen erstrecken, daß die wirksamen Kathoden in der Nähe der äußeren Bereiche breiter sind als in der Nähe des mittleren Bereichs der Halbleiteranordnung und daß die Umfangsbreiten der Teile der Schicht (15) mit geringerem spezifischem Widerstand, die an die Spalte angrenzen, in einem mittleren Bereich der Halbleiteranordnung minimal sind und mit der Entfernung vom mittleren Bereich ansteigen.

2. Von einem Gate gesteuerte Halbleiteranordnung nach Anspruch 1, ferner dadurch gekennzeichnet, daß die Teile der Schicht (15) mit niedrigerem spezifischem Widerstand mehrere sich radial erstreckende Bereiche (15b) umfassen.

3. Von einem Gate gesteuerte Halbleiteranordnung nach anspruch 2, ferner dadurch gekennzeichnet, daß die sich radial erstreckenden Bereiche Kreissektoren bilden.

4. Von einem Gate gesteuerte Halbleiteranordnung nach einem der vorstehenden Ansprüche, ferner dadurch gekennzeichnet, daß ein Einschalt-Gateanschluß (9) und eine metallische Schicht (8) an einem mittleren Bereich des Elements (1) vorgesehen sind.

## FIG.1

## FIG.2

# FIG. 3

# FIG. 4

## FIG.5

### (a)

### (b)

### (c)

FIG.6

FIG.7